# EUROPEAN PATENT APPLICATION

(11) **EP 4 510 187 A1**
(43) Date of publication of application: **19.02.2025**
(21) Application number: 24183699.8
(22) Date of filing: 21.06.2024
(51) Int. Cl.: H01L 25/065

(54) **PACKAGE ARCHITECTURE WITH BRIDGE DIES HAVING AIR GAPS AROUND VIAS**

(30) Priority: 17.08.2023 US 202318451150
(71) Applicant: INTEL Corporation, Santa Clara, CA 95054 (US)
(72) Inventor: Marin, Brandon C., Gilbert, 85234 (US); Duan, Gang, Chandler, 85248 (US); Pietambaram, Srinivas V., Chandler, 85249 (US); Ecton, Jeremy, Gilbert, 85298 (US)
(74) Representative: Goddar, Heinz J.

(57) **Abstract**

Embodiments of a semiconductor die comprise: a first bond-pad on a first surface to couple to a package substrate, a second bond-pad on a second surface, the second surface being opposite to the first surface, a hole through the semiconductor die, a conductive pillar within the hole separated from sidewalls of the hole by an air gap, the conductive pillar coupled to the first bond-pad and the second bond-pad, and pathways conductively coupling at least two integrated circuit (IC) dies proximate to the second surface.

## Description

### TECHNICAL FIELD

The present disclosure relates to techniques, methods, and apparatus directed to a package architecture with bridge dies having air gaps around vias.

### BACKGROUND

Electronic circuits, when commonly fabricated on a wafer of semiconductor material, such as silicon, are called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system, or servers, such as mainframes.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic cross-sectional view of an example microelectronic assembly according to some embodiments of the present disclosure.
FIG. 2A is a schematic cross-sectional view of an example via with air gap in the microelectronic assembly of FIG. 1 according to some embodiments of the present disclosure.
FIG. 2B is a schematic cross-sectional view of another example via with air gap in the microelectronic assembly of FIG. 1 according to some other embodiments of the present disclosure.
FIG. 2C is a schematic plan view of the example via with air gap of FIG. 2A.
FIG. 3 is a schematic cross-sectional view of a portion of the example microelectronic assembly of FIG. 1 according to another embodiment of the present disclosure.
FIG. 4 is a simplified sectional plan view of a detail in an example microelectronic assembly according to various embodiments of the present disclosure.
FIGS. 5A-5D are simplified cross-sectional views of various stages of manufacture of an example via with air gap according to various embodiments of the present disclosure.
FIG. 6 is a top view of a wafer that includes one or more semiconductor dies of the microelectronic package in accordance with any of the embodiments disclosed herein.
FIG. 7 is a cross-sectional view of a device package that includes one or more microelectronic assemblies in accordance with any of the embodiments disclosed herein.
FIG. 8 is a cross-sectional side view of a device assembly that includes one or more microelectronic assemblies in accordance with any of the embodiments disclosed herein.
FIG. 9 is a block diagram of an example computing device that includes one or more microelectronic assemblies in accordance with any of the embodiments disclosed herein.

### DETAILED DESCRIPTION

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

The demand for miniaturization of form factor and increased levels of integration for high performance are driving sophisticated packaging approaches in the semiconductor industry. Advances in semiconductor processing and logic design have permitted an increase in the amount of logic circuits that may be included in processors and other IC devices. As a result, many processors now have multiple cores that are monolithically integrated on a single die. Generally, these types of monolithic ICs are also described as planar since they take the form of a flat surface and are typically built on a single silicon wafer made from a monocrystalline silicon boule. The typical manufacturing process for such monolithic ICs is called a planar process, allowing photolithography, etching, heat diffusion, oxidation, and other such processes to occur on the surface of the wafer, such that active circuit elements *(e.g.,* transistors and diodes) are formed on the planar surface of the silicon wafer.

Current technologies permit hundreds and thousands of such active circuit elements to be formed on a single die so that numerous logic circuits may be enabled thereon. In such monolithic dies, the manufacturing process must be optimized for all the circuits equally, resulting in trade-offs between different circuits. In addition, because of the limitation of having to place circuits on a planar surface, some circuits are farther apart from some others, resulting in decreased performance such as longer delays. The manufacturing yield may also be severely impacted because the entire die may have to be discarded if even one circuit is malfunctional.

One solution to overcome such negative impacts of monolithic dies is to disaggregate the circuits into smaller dies (*e.g.*, chiplets, tiles) electrically coupled by interconnect bridges. The smaller dies are part of an assembly of interconnected dies that together form a complete IC in terms of application and/or functionality, such as a memory chip, microprocessor, microcontroller, commodity IC (e.g., chip used for repetitive processing routines, simple tasks, application specific IC, etc.), and system-on-a-chip (SOC). In other words, the individual dies are connected to create the functionalities of a monolithic IC. By using separate dies, each individual die can be designed and manufactured optimally for a particular functionality. For example, a processor core that contains logic circuits might aim for performance, and thus might require a very speed-optimized layout; this has different manufacturing requirements compared to a USB controller, which is built to meet certain USB standards, rather than for processing speed; by having different parts of the overall design separated into different dies, each one optimized in terms of design and manufacturing, the overall yield and cost of the combined die solution may be improved.

The connectivity between these dies is achievable in many ways. For example, in 2.5D packaging solutions, a silicon interposer and through-silicon vias (TSVs) connect dies at silicon interconnect speed in a minimal footprint. In another example, a silicon bridge embedded under the edges of two interconnecting dies facilitates electrical coupling between them. The bridge die may be embedded in a package substrate, which allows for top-packaged chips to communicate with other chips horizontally using the bridge die and vertically, using Through-Mold Vias (TMVs) in the package substrate. Such die partitioning enables miniaturization of small form factor and high performance without yield issues seen with other methods but needs fine die-to-die interconnections. The bridge die can facilitate such high-density interconnections by inserting the bridge dies only where needed.

However, many bridge dies are limited in power delivery due to the lack of TSVs. Although bridge dies can be made with TSVs, electrical parasitics (e.g., resistance, capacitance, inductance, etc.) of such TSVs can limit their electrical effectiveness. Therefore, currently, power delivery with bridge dies is implemented by routing around the bridge dies, leading to design restrictions in routing and trace placement on dies and substrates.

Accordingly, embodiments described herein enable an IC package that includes a package substrate having a surface with a blind cavity extending partially through the package substrate from the surface, a plurality of IC dies attached to the surface of the package substrate, and a bridge die in the blind cavity attached to the plurality of IC dies. The bridge die has conductive pathways conductively coupling IC dies in the plurality if IC dies, TSVs extending through a thickness of the bridge die, and an air gap around at least one TSV. The air gap serves to decrease parasitics such as impedence and dielectric constant, and corresponding loss around the TSV.

Some embodiments described herein enable a semiconductor die such as the bridge die, having a first bond-pad on a first surface to couple to a package substrate, a second bond-pad on a second surface, the second surface being opposite to the first surface, a hole through the semiconductor die, the hole having a first end at the first surface and a second end at the second surface, a conductive pillar within the hole separated from sidewalls of the hole by an air gap, the conductive pillar being directly coupled to the first bond-pad and the second bond-pad, and pathways conductively coupling at least two IC dies proximate to the second surface.

Some other embodiments described herein provide a package substrate, including buildup layers, a cavity in the buildup layers, and a semiconductor die in the cavity. The semiconductor die has a plurality of conductive vias proximate to a periphery thereof. Each conductive via may extend through a thickness of the semiconductor die, and an air gap may surround each conductive via.

Embodiments disclosed herein further provide for a method to fabricate air gaps around conductive vias through bridge dies, the method including providing a wafer of semiconductor material having a first surface and an opposing second surface, forming through-holes in the wafer, each through-hole extending through a thickness of the wafer between the first surface and the second surface, adding conductive material in the through-hole such that a gap exists laterally between sidewalls of each through-hole and the conductive material, and forming bond-pads on the first surface and the second surface, at least a subset of the bond-pads covering each through-hole on the first surface and the second surface such that the conductive material in each through-hole is directly coupled to bond-pads on the first surface and the second surface. The through-hole may be formed by reactive ion etching in some embodiments.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may comprise substantially monocrystalline semiconductors, such as silicon or germanium, as a base material *(e.g.,* substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may comprise alternate materials, which may or may not be combined with silicon that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (*e.g*., Al, Ga, In), and a second sub-lattice of at least one element of group V of the periodic table (*e.g*., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (*e.g*., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (*e.g*., ICs implementing one or more of memory devices, memory arrays, control logic configured to control the memory devices and arrays, etc.). In another such example, the term "compute die" may be used to describe a die that includes one or more ICs implementing logic/compute circuitry (*e.g*., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may comprise a semiconductor material including, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may comprise a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field effect transistors (FETs), *e.g.,* MOSFETs. In many embodiments, an FET is a four-terminal device. In SOI, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (*e.g.,* silicon dioxide or SiO₂), borosilicate (*e.g.,* 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and PCBs such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (*e.g*., PCB or Printed Wiring Boards (PWB)), glass, ceramic, silicon, silicon carbide, etc. In addition, as used herein, a package substrate may refer to a substrate that includes buildup layers (*e.g*., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, die-to-die (DTD) interconnects and die-to-package substrate (DTPS) interconnects. DTD interconnects may also be referred to as first-level interconnects (FLI). DTPS interconnects may also be referred to as Second-Level Interconnects (SLI).

Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects.

In some embodiments, the pitch of the DTD interconnects may be different from the pitch of the DTPS interconnects, although, in other embodiments, these pitches may be substantially the same.

The DTPS interconnects disclosed herein may take any suitable form. In some embodiments, a set of DTPS interconnects may include solder (*e.*g., solder bumps or balls that are subject to a thermal reflow to form the DTPS interconnects). DTPS interconnects that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of DTPS interconnects may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film *(e.g.,* a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

The DTD interconnects disclosed herein may take any suitable form. In some embodiments, some or all of the DTD interconnects in a microelectronic assembly or an IC package as described herein may be metal-to-metal interconnects (*e.g*., copper-to-copper interconnects, or plated interconnects). In such embodiments, the conductive contacts on either side of the DTD interconnect may be bonded together (*e.g*., under elevated pressure and/or temperature) without the use of intervening solder or an anisotropic conductive material. In some metal-to-metal interconnects, a dielectric material (*e.g*., silicon oxide, silicon nitride, silicon carbide) may be present between the metals bonded together (*e.g*., between copper pads or posts that provide the associated conductive contacts). In some embodiments, one side of a DTD interconnect may include a metal pillar (*e.g*., a copper pillar), and the other side of the DTD interconnect may include a metal contact (*e.g.*, a copper contact) recessed in a dielectric. In some embodiments, a metal-to-metal interconnect (*e.g*., a copper-to-copper interconnect) may include a noble metal *(e.g.,* gold) or a metal whose oxides are conductive (*e.g.,* silver). In some embodiments, a metal-to-metal interconnect may include metal nanostructures (*e.g*., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, the dies on either side of a set of DTD interconnects may be bare (*e.g.*, unpackaged) dies.

In some embodiments, the DTD interconnects may include solder. For example, the DTD interconnects may include conductive bumps or pillars (*e.g*., copper bumps or pillars) attached to the respective conductive contacts by solder. In some embodiments, a thin cap of solder may be used in a metal-to-metal interconnect to accommodate planarity, and this solder may become an intermetallic compound during processing. In some embodiments, the solder used in some or all of the DTD interconnects may have a higher melting point than the solder included in some or all of the DTPS interconnects. For example, when the DTD interconnects in an IC package are formed before the DTPS interconnects are formed, solder-based DTD interconnects may use a higher-temperature solder (*e.g*., with a melting point above 200 degrees Celsius), while the DTPS interconnects may use a lower-temperature solder (*e.g.*, with a melting point below 200 degrees Celsius). In some embodiments, a higher-temperature solder may include tin; tin and gold; or tin, silver, and copper (*e.g*., 96.5 % tin, 3% silver, and 0.5% copper). In some embodiments, a lower-temperature solder may include tin and bismuth (*e.g.*, eutectic tin bismuth), tin, silver, bismuth, indium, indium and tin, or gallium.

In some embodiments, a set of DTD interconnects may include an anisotropic conductive material, such as any of the materials discussed above for the DTPS interconnects. In some embodiments, the DTD interconnects may be used as data transfer lanes, while the DTPS interconnects may be used for power and ground lines, among others.

In microelectronic assemblies or IC packages as described herein, some or all of the DTD interconnects may have a finer pitch than the DTPS interconnects. In some embodiments, the DTPS interconnects disclosed herein may have a pitch between about 80 microns and 300 microns, while the DTD interconnects disclosed herein may have a pitch between about 0.5 microns and 100 microns, depending on the type of the DTD interconnects. An example of silicon-level interconnect density is provided by the density of some DTD interconnects. In some embodiments, the DTD interconnects may have too fine a pitch to couple to the package substrate directly (*e.g*., too fine to serve as DTPS interconnects). The DTD interconnects may have a smaller pitch than the DTPS interconnects due to the greater similarity of materials in the different dies on either side of a set of DTD interconnects than between a die and a package substrate on either side of a set of DTPS interconnects. In particular, the differences in the material composition of dies and package substrates may result in differential expansion and contraction of the die dies and package substrates due to heat generated during operation (as well as the heat applied during various manufacturing operations). To mitigate damage caused by this differential expansion and contraction (*e.g*., cracking, solder bridging, etc.), the DTPS interconnects in any of the microelectronic assemblies or IC packages as described herein may be formed larger and farther apart than DTD interconnects, which may experience less thermal stress due to the greater material similarity of the pair of dies on either side of the DTD interconnects.

It will be recognized that one more levels of underfill (*e.g*., organic polymer material such as benzotriazole, imidazole, polyimide, or epoxy) may be provided in an IC package described herein and may not be labeled in order to avoid cluttering the drawings. In various embodiments, the levels of underfill may comprise the same or different insulating materials. In some embodiments, the levels of underfill may comprise thermoset epoxies with silicon oxide particles; in some embodiments, the levels of underfill may comprise any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (*e.g*., epoxy liquid, liquid photo-imageable polymers, dry film photo-imageable polymers, acrylics, solvents) may be provided in an IC package described herein and may not be labeled or shown to avoid cluttering the drawings. Solder resist may be a liquid or dry film material including photo-imageable polymers. In some embodiments, solder resist may be non-photo-imageable.

The terms "substantially," "close," "approximately," "near," and "about," generally refer to being within +/- 20% of a target value (*e.g*., within +/- 5% or 10% of a target value) based on the context of a particular value as described herein or as known in the art.

Terms indicating orientation of various elements, *e.g*., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (*e.g*., interconnects) are shown as aligned *(e.g.,* at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (*e.g*., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

For convenience, if a collection of drawings designated with different letters are present *(e.g.,* FIGS. 10A-10C), such a collection may be referred to herein without the letters *(e.g.,* as "FIG. 10"). Similarly, if a collection of reference numerals designated with different letters are present (*e.g*., 112a-112e), such a collection may be referred to herein without the letters (*e.g*., as "112").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

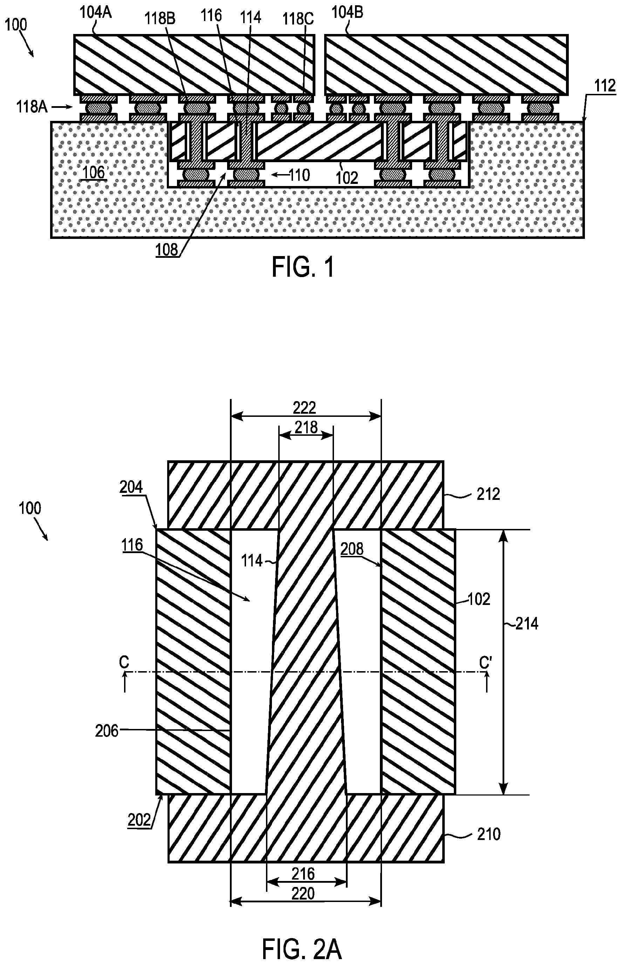

FIG. 1 is a schematic cross-sectional view of an example microelectronic assembly 100 according to some embodiments of the present disclosure. Microelectronic assembly 100 comprises a bridge die 102 providing conductive pathways to electrically couple two (or more) IC dies 104, for example 104a and 104b. Note that although two IC dies 104a and 104b are shown in the figure, more than two IC dies 104 may be conductively coupled by bridge die 102 within the broad scope of the embodiments. Bridge die 102 comprises a semiconductor material, such as silicon or other materials as listed in the previous subsection as being suitable for IC dies, and may be referred to as semiconductor die 102 also herein.

Bridge die 102, and IC dies 104 may be coupled to a package substrate 106. Package substrate 106 may comprise a plurality of buildup layers of organic material (e.g., polyimide, epoxy, etc.) with conductive traces and vias, comprising, for example, copper. In some other embodiments, package substrate 106 may comprise an inorganic material, such as ceramic. Any suitable materials may be provided in package substrate 106 within the broad scope of the embodiments. In various embodiments, bridge die 102 may be in a blind cavity 108 in package substrate 106 and coupled thereto by interconnects 110. Cavity 108 may extend partially into package substrate 106 from surface 112 of package substrate 106. In some embodiments (not shown) a die attach adhesive may be present between bridge die 102 and a bottom of cavity 108. In some other embodiments (not shown), interconnects 110 may be surrounded by underfill material. Bridge die 102 may include one or more conductive pillars 114 extending therethrough. The one or more conductive pillars 114 may be surrounded by respective air gaps 116.

During operation, conductive pillars 114 may function as through-silicon vias (TSVs), enabling electrical connectivity between package substrate 106 and IC dies 104. In some such embodiments, conductive pillars 114 may form part of a power delivery network for high-frequency applications, serving to deliver power to IC dies 104 from (or through) package substrate 106; in such embodiments, air gaps 116 may improve electrical performance of conductive pillars 114, for example, by reducing parasitic loss from impedance. Merely as an illustration and not as a limitation, bridge die 102 that does not have air gaps 116 around conductive pillars 114 may be capable of delivering current of 1.2 mA to IC dies 104, whereas with air gaps 116 around conductive pillars 114, the current delivered may be approximately 7 mA, everything else remaining the same.

IC dies 104a and 104b may be coupled to package substrate 106 and bridge die 102 by interconnects 118. interconnects 118a may couple IC die 104a to package substrate 106; interconnects 118b may couple IC die 104a to conductive vias 114 and interconnects 118c may couple IC die 104a to conductive pathways (not shown) that conductively couple IC die 104a with IC die 104b through bridge die 102. interconnects 118 may be of a plurality of types in some embodiments. In various embodiments, interconnects 118a may comprise SLIs, interconnects 118b and 118c may comprise FLls. In some such embodiments, interconnects 118a may be similar in size and pitch to interconnects 118b and/or interconnects 110, and different in size and pitch from interconnects 118c. In other embodiments, interconnects 118 may be similar in size and pitch across surface 112. Interconnects 118 and 110 may comprise solder in various embodiments. In other embodiments, interconnects 118 and/or 110 may be of other types (e.g., copper-pillar based, hybrid bonds, etc.) as listed in the previous subsection.

FIG. 2A is a simplified cross-sectional view of an example conductive via 114 surrounded by air gap 116. Bridge die 102 may have two opposing surfaces 202 and 204. In some embodiments, surface 202 may be proximate to a bottom of cavity 108 and surface 204 may be proximate to IC dies 104; in other embodiments, the configuration may be reversed so that surface 202 is proximate to IC dies 104 and surface 204 is proximate to bottom of cavity 108. A hole 206 having sidewalls 208 may extend between surfaces 202 and 204. A bond-pad 210 may cover an end of hole 206 at surface 202. Another bond-pad 210 may cover an opposite end of hole 206 at surface 204. Conductive pillar 114 may be within hole 206 and separated from sidewalls 208 by air gap 116. Conductive pillar 114 may be directly attached to bond-pads 210 and 212. Bond-pads 210 and/or 212 may be substantially larger than hole 206 such that there is no significant structural buckling or other problems due to the absence of solid material around conductive pillar 114 proximate to bond-pads 210 and/or 212.

In various embodiments, bridge die 102 may have a thickness 214. Conductive pillar 114 may extend through the entirety of thickness 214. Conductive pillar 114 may be fabricated using an additive manufacturing process, such as physical vapor deposition. This differs from conventional electroplating techniques used to fabricate TSVs in silicon dies. Conventional electroplating techniques generally completely fill any available space with the electroplated material, preventing any air gaps from forming intentionally (e.g., voids may occur due to various process conditions, but such voids are uncontrolled and typically undesired). Therefore, such conventional electroplating techniques may not be suitable for fabricating conductive pillar 114 with controlled air gap 116 around it. Consequently, liner materials and seed materials, which are aspects of the electroplating process, may be absent around conductive pillar 114 in various embodiments.

The fabrication process as used in embodiments herein may sequentially deposit layers of the conductive material, for example, copper, within hole 206, resulting in a tapered shape of conductive pillar 114 toward surface 204, such that conductive pillar 114 is wider proximate to surface 202 than to surface 204. Because conductive pillar 114 is unsupported around its periphery by any solid material, its structural integrity may depend on its height to width ratio. For example, the taller conductive pillar 114 is, the less structural integrity it may have and the more prone it may be to buckling and/or breaking. On the other hand, the wider conductive pillar 114 is, the higher is its structural integrity and the less prone it may be to breaking. Hence, the process to fabricate conductive pillar 114 may be suitably chosen based upon the degree of control that can be exercised over the height to width ratio of conductive pillar 114. In an example embodiment, electron beam physical vapor deposition at pressures below 1 microbar may be used to fabricate conductive pillar 114 to achieve desired shapes based on particular needs.

Further, the height of conductive pillar 114 is directly proportional to thickness 214 of bridge die 102. Thus, thickness 214 of bridge die 102 may inform (e.g., affect, limit, etc.) a width (e.g., diameter) 216 of conductive pillar 114 at surface 202 and a width (e.g., diameter) 218 of conductive pillar 114 at surface 204. For example, consider two different bridge dies 102a and 102b, having respective thickness 214a and 214b. Assume, merely for the sake of explanation that thickness 214a is greater than thickness 214b. Assume also that conductive pillar 114a in bridge die 102a has the same width 216 at surface 202 as another conductive pillar 114b in bridge die 102b. Correspondingly, width 218a of conductive pillar 114a in bridge die 102a may be smaller than width 218b of conductive pillar 114b due to the greater thickness 214a of bridge die 102a given the same height to width ratio (i.e., taper) of conductive pillars 114a and 114b.

The shape of hole 206 may directly affect the shape of air gap 116. Because the presence, size and shape of air gap 116 affects the electrical performance of conductive pillar 114 during operation, the shape of hole 206 and the width of conductive pillar 114 may be such as to preserve air gap 116 according to desired electrical characteristics of conductive pillar 114 during operation. In various embodiments, hole 206 may be formed by reactive ion etching. Many process parameters may be tuned to generate hole 206 having suitably tapered, vertical, or re-entrant sidewalls 208 as desired and based on particular needs. In some embodiments, as shown, hole 206 has substantially vertical sidewalls 208, with width 220 proximate to surface 202 that is substantially similar to width 222 proximate to surface 204.

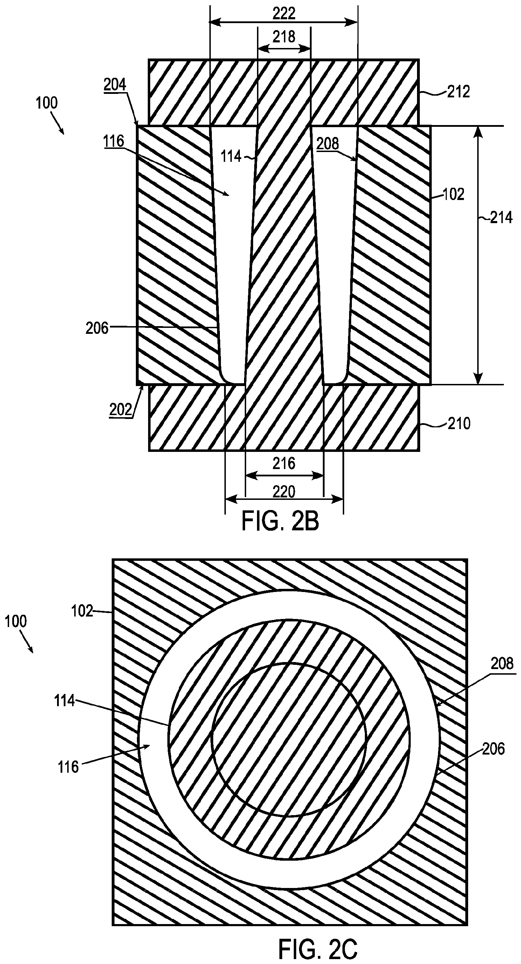

FIG. 2B shows another embodiment, in which, depending on the process parameters, hole 206 has tapered sidewalls 208, with width 220 proximate to surface 202 being smaller than width 222 proximate to surface 204. Sidewalls 208 may also have additional features, such as a chamfer (e.g., bevel), undercut, notches, or other shape created by the etching process. In some other embodiments (not shown), hole 206 may have re-entrant sidewalls 208, with width 220 proximate to surface 202 that is greater than width 222 proximate to surface 204. Any suitable sidewall profile may be provided based on particular needs within the broad scope of the embodiments. Thus, the overall size and shape of conductive pillar 114 and air gap 116 may be based on (among other factors) (i) fabrication process of conductive pillar 114 and hole 206, (ii) structural integrity of conductive pillar 114 in view of thickness 214 of bridge die 102, and (iii) desired electrical performance of conductive pillar 114 during operation.

In various embodiments, thickness 214 of bridge die 102 may vary between 1 micron and 500 microns. Width 216 of conductive pillar 114 proximate to surface 202 (e.g., facing bottom of blind cavity 108) may vary between 0.5 micron and 100 microns. Width 218 of conductive pillar 114 proximate to surface 204 (e.g., facing dies 104) may vary between 0.5 micron and 200 microns. The average width of conductive pillar 114 may vary between 0.5 micron and 100 microns. Width 220 of hole 206 proximate to surface 202 (e.g., facing bottom of blind cavity 108) may vary between 5 microns and 400 microns. Width 222 of hole 206 proximate to surface 204 (e.g., facing dies 104) may vary between 6 microns and 600 microns.

A plan view of conductive pillar 114 and air gap 116 across section CC' is shown in FIG. 2C. Note that in the figure, hole 206 and conductive pillar 114 are shown as circular structures. Such is merely for ease of illustration and should not be construed as a limitation. Hole 206 and conductive pillar 114 may be of any suitable shape in cross-section within the broad scope of the embodiments herein.

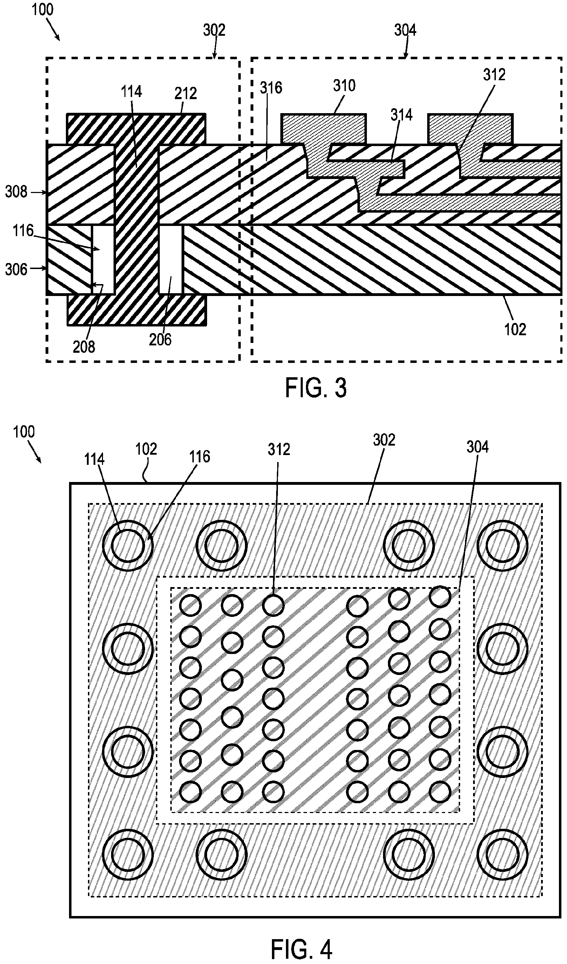

FIG. 3 is a schematic cross-sectional view of a portion of microelectronic assembly 100 according to an embodiment of the present disclosure. Bridge die 102 may comprise two mutually exclusive portions 302 and 304. Conductive pillars 114 may be disposed in portion 304 and conductive pathways to conductively couple IC dies 104 may be provisioned in portion 304. Bridge die may comprise a semiconductor substrate portion 306, comprising, for example, a semiconductor material such as bulk silicon. Other example materials are listed in the previous subsection. A back-end-of-line (BEOL) portion 308 may be provided over semiconductor substrate 306. Bridge die 102 may not comprise any front-end-of-line (FEOL) portion having active semiconductor elements such as transistors and diodes in various embodiments. The conductive pathways to conductively couple IC dies 104 may be disposed in BEOL portion 308. The conductive pathways may comprise bond-pads 310 coupled by conductive vias 312 to layers of metallization including conductive traces 314 in an interlayer dielectric (ILD) material 316. Examples of ILD material include compounds comprising silicon and oxygen (e.g., silicon dioxide), silicon, oxygen and nitrogen (e.g., silicon oxynitride), silicon and nitrogen (e.g., silicon nitride), etc. as listed in the previous subsection. ILD material 316 may be disposed in layers between conductive traces 314 and between layers of conductive traces 314. Conductive vias 312 may be disposed in ILD material 316 between layers of conductive traces 314. Bond-pads 310 may be directly coupled to interconnects 118 (e.g., 118c) of IC dies 104. In various embodiments, bond-pads 212 may be larger (e.g., of greater diameter, wider, etc.) than bond-pads 310. Bond-pads 212 may be distributed at a larger pitch than bond-pads 310 in some embodiments. Conductive pillar 114 may be wider than conductive vias 312 in various embodiments.

In various embodiments (not shown), hole 206 may pass through semiconductor substrate 306 and BEOL portion 308 as discussed in reference to the previous figures. In some such embodiments, hole 206 and conductive pillars 114 may be formed in a via last process after fabrication of BEOL portion 308. In some other embodiments (as shown), hole 206 may exist only in semiconductor substrate 306, and conductive pillar 114 may comprise a conductive via through ILD material 316 without air gap 116 in BEOL portion 308. Note that the drawing is not to scale and BEOL portion 308 may be orders of magnitude thinner than semiconductor substrate 306. The thickness of BEOL portion 308 may vary depending on the number of layers of metallization and can range between 2 microns and 200 microns. Therefore, the lack of air gap 116 in BEOL portion 308 may not significantly affect the overall electrical characteristics of conductive pillar 114 in embodiments where BEOL portion 308 is relatively thin. In some such embodiments, hole 206 may be formed before fabricating BEOL portion 308, and conductive pillar 114 may be completed during fabrication of BEOL portion 308.

FIG. 4 is a simplified sectional plan view of a detail in microelectronic assembly 100 according to various embodiments of the present disclosure. Portion 302 may be disposed along a periphery of bridge die 102 and portion 304 comprising the conductive pathways may be provisioned towards the center of bridge die 102. In the sectional plan view shown, bond-pads 212 and 310 have been removed, exposing conductive pillars 114, air gaps 116, and vias 312. Note that the drawing is not to scale merely for ease of illustration. Any number of conductive pillars 114 and vias 312 may be provisioned in bridge die 102 without departing from the scope of the embodiments. Further, although portion 304 is shown surrounding portion 302, in some embodiments, portion 302 may extend to the periphery in some regions. Nevertheless, portions 302 and 304 may be mutually exclusive so that conductive pillars 114 with air gaps 116 may not be disposed among vias 312 and conductive traces 314.

In various embodiments, any of the features discussed with reference to any of FIGS. 1-4 herein may be combined with any other features to form a package with one or more IC dies as described herein. For example, in some embodiments, several ones of bridge die 102 may be present. In some embodiments, some conductive pillars 114 may be surrounded by air gaps 116 and other conductive pillars 114 may not be surrounded by air gaps 116 based on particular needs. Some such combinations are described above, but, in various embodiments, further combinations and modifications are possible. Various different embodiments described in different figures may be combined suitably based on particular needs within the broad scope of the embodiments.

### Example methods

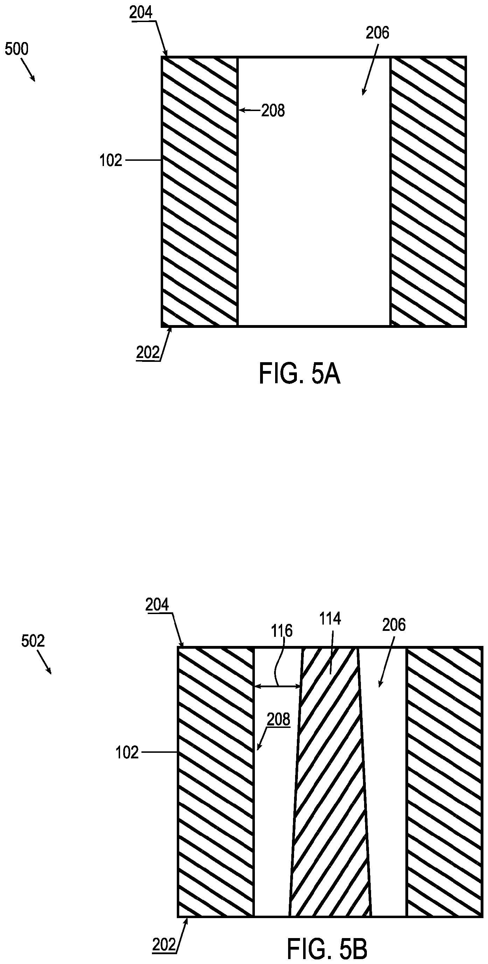

FIGS. 5A-5D are schematic cross-sectional views of portions of microelectronic assembly 100 at various stages of manufacture according to some embodiments of the present disclosure. Note that only a portion of the structures are shown in the figures for ease of illustration. In practice, the processes may be performed at wafer-level or panel-level as desired and based on particular needs. In FIG. 5A, operation 500 is shown, at which a wafer comprising bridge die 102 may be provided. Hole 206 may be formed in bridge die 102 at desired locations, for example, by the suitable use of masks and reactive ion etching process. Controlling process parameters suitably can enable a desired profile for sidewalls 208 of hole 206. In various embodiments, bridge die 102 may comprise only semiconductor substrate 306 at this stage. In other embodiments, bridge die 102 may also comprise BEOL portion 308 so that hole 206 is formed through BEOL portion 308 also.

FIG. 5B shows operation 502 subsequent to operation 500. At 502, conductive pillar 114 is formed within hole 206. Note that the wafer containing bridge die 102 may be supported on a suitable surface (e.g., chuck, panel, etc.) lined with a material that enables easy removal of the conductive material therefrom so that conductive pillar 114 is deposited on the lined surface within hole 206. Conductive material (e.g., copper) may be deposited in hole 206 by an additive process such as e-beam physical vapor deposition at low pressure, for example 1 microbar. The process may be chosen to enable control over the height to width ratio of conductive pillar 114 as it is formed in a tapered shape within hole 206. In the figure, conductive pillar 114 is shown tapering towards surface 204 whereas hole 206 tapers away from surface 204. In other embodiments, sidewalls 208 of hole 206 may be vertical. In yet other embodiments, sidewalls 208 of hole 206 may taper towards surface 204. All such variations are included within the broad scope of the embodiments. The process parameters for depositing the conductive material to form conductive pillar 114 may be suitably controlled so that it does not fill hole 206 entirely, and leaves air gap 116 between conductive pillar 114 and sidewalls 208 of hole 206.

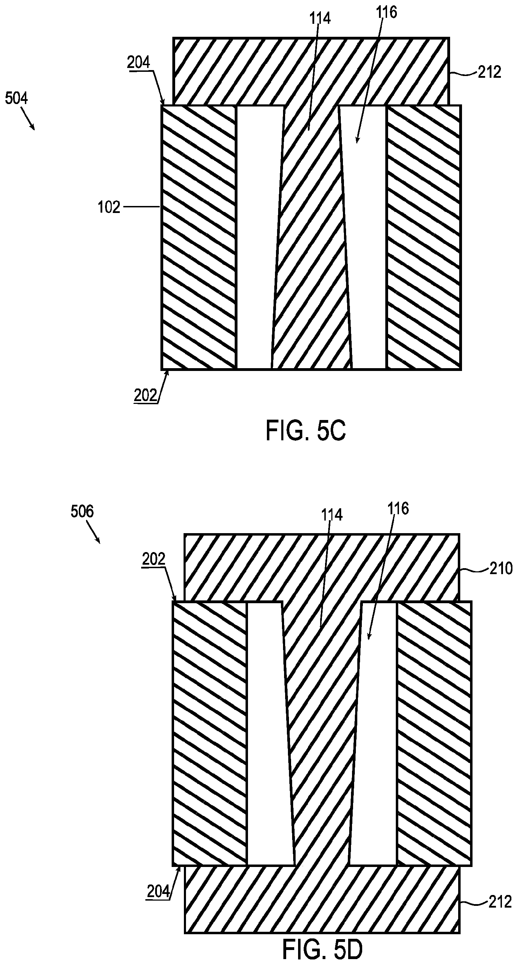

FIG. 5C shows operation 504, subsequent to operation 502. At 504, bond-pad 212 may be formed on surface 204, for example, by electroplating. Another method that may be used to form bond-pad 212 is low pressure chemical vapor deposition (CVD) of conductive metals. This method is a linear deposition method that does not fill material laterally, which prevents hole 206 from filling with the conductive material while preserving air gap 116 during formation of bond-pad 212. In some other embodiments, BEOL portion 308 may be formed in another operation between operation 504 and 502, and conductive pillar 114 extended through BEOL portion 308 with conventional via forming process to form structures as described in reference to FIG. 3.

FIG. 5D shows operation 506, subsequent to operation 504. The wafer containing bridge die 102 may be flipped and bond-pad 210 on surface 202 may be formed, for example, by electroplating or low pressure CVD, for example, similar to forming bond-pad 212. In various embodiments, chemical mechanical polishing may be performed before any electroplating, for example, to expose conductive pillar 114 for seeding processes associated with electroplating.

Although FIGS. 5A-5D illustrate various operations performed in a particular order, this is simply illustrative, and the operations discussed herein may be reordered and/or repeated as suitable. Further, additional processes which are not illustrated may also be performed without departing from the scope of the present disclosure. Also, various ones of the operations discussed herein with respect to FIGS. 5A-5D may be modified in accordance with the present disclosure to fabricate others of microelectronic assembly 100 disclosed herein. Although various operations are illustrated in FIGS. 5A-5D once each, the operations may be repeated as often as desired. For example, one or more operations may be performed in parallel to manufacture and test multiple microelectronic assemblies substantially simultaneously. In another example, the operations may be performed in a different order to reflect the structure of a particular microelectronic assembly in which one or more substrates or other components as described herein may be included.

Furthermore, the operations illustrated in FIGS. 5A-5D may be combined or may include more details than described. For example, the operations may be modified suitably without departing from the scope of the disclosure for IC dies that do not have a semiconductor substrate, but rather, are fabricated on other materials, such as glass or ceramic materials. Still further, the various operations shown and described may further include other manufacturing operations related to fabrication of other components of the microelectronic assemblies described herein, or any devices that may include the microelectronic assemblies as described herein. For example, the operations not shown in the figure may include various cleaning operations, additional surface planarization operations, operations for surface roughening, operations to include barrier and/or adhesion layers as desired, and/or operations for incorporating microelectronic assemblies as described herein in, or with, an IC component, a computing device, or any desired structure or device.

### Example devices and components

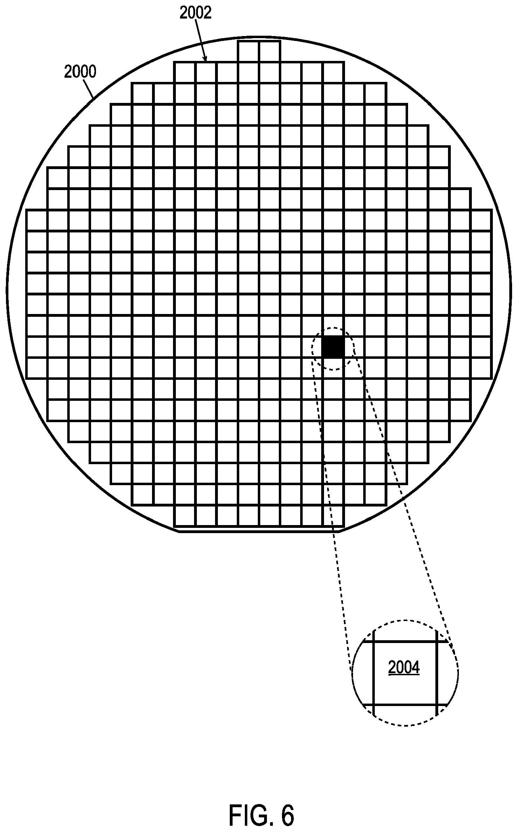

The packages disclosed herein, *e.g.*, any of the embodiments shown in FIGS. 1-5 or any further embodiments described herein, may be included in any suitable electronic component. FIGS. 6-9 illustrate various examples of packages, assemblies, and devices that may be used with or include any of the IC packages as disclosed herein.

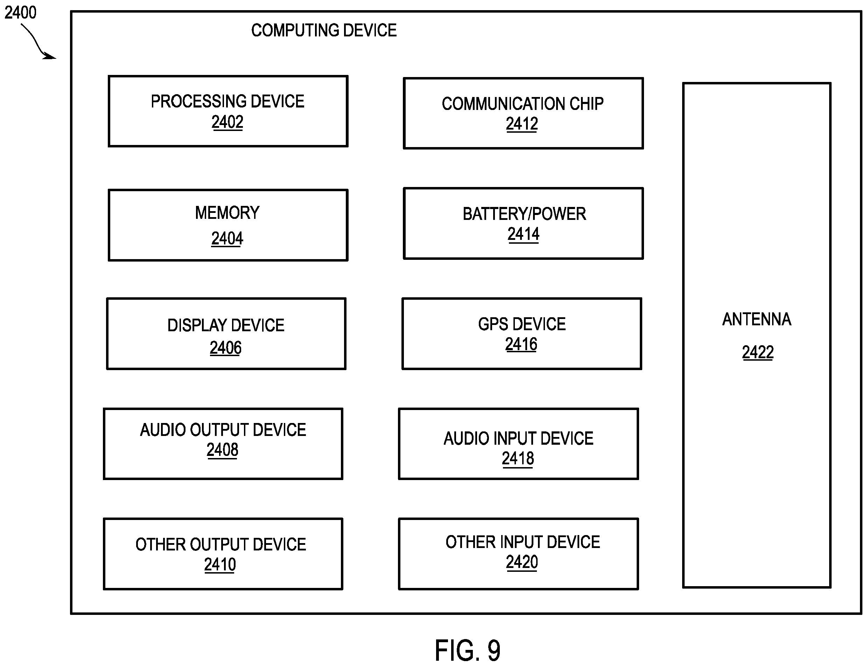

FIG. 6 is a top view of a wafer 2000 and dies 2002 that may be included in any of microelectronic assemblies 100 disclosed herein. Wafer 2000 may be composed of semiconductor material and may include one or more dies 2002 having IC structures formed on a surface of wafer 2000. The individual dies 2002 may be a repeating unit of an IC product that includes any suitable IC. After the fabrication of the semiconductor product is complete, wafer 2000 may undergo a singulation process in which dies 2002 are separated from one another to provide discrete "chips" (e.g., example die 2004) of the IC product. Example die 2004 may be any of dies 102 and 104 disclosed herein. Die 2004 may include one or more transistors, supporting circuitry to route electrical signals to the transistors, passive components (e.g., signal traces, resistors, capacitors, or inductors), and/or any other IC components. In some embodiments, wafer 2000 or die 2004 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 2004. For example, a memory array formed by multiple memory devices may be formed on a same die 2004 as a processor unit (e.g., processing device 2402 of FIG. 9) or other logic that is configured to store information in the memory devices or execute instructions stored in the memory array as described in the other figures herein. Various ones of the microelectronic assemblies disclosed herein may be manufactured using a die-to-wafer assembly technique in which some dies are attached to wafer 2000 that include other dies and wafer 2000 is subsequently singulated.

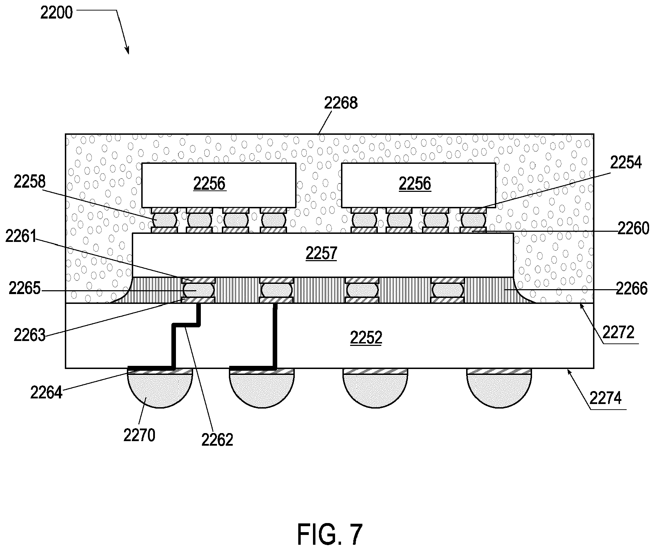

FIG. 7 is a side, cross-sectional view of an example IC package 2200 that may include IC packages in accordance with any of the embodiments disclosed herein. In some embodiments, the IC package 2200 may be a SIP. At least some of the components described in FIG. 7 may be substantially similar to the components described in the preceding figures, for example, FIG. 1.

As shown in the figure, package substrate 2252 may be formed of an insulator (*e.g*., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (*e.g*., metal) serving as an interface between different components; conductive contacts may be recessed in, flush with, or extending away from a surface of a component, and may take any suitable form (*e.g.*, a conductive pad or socket).

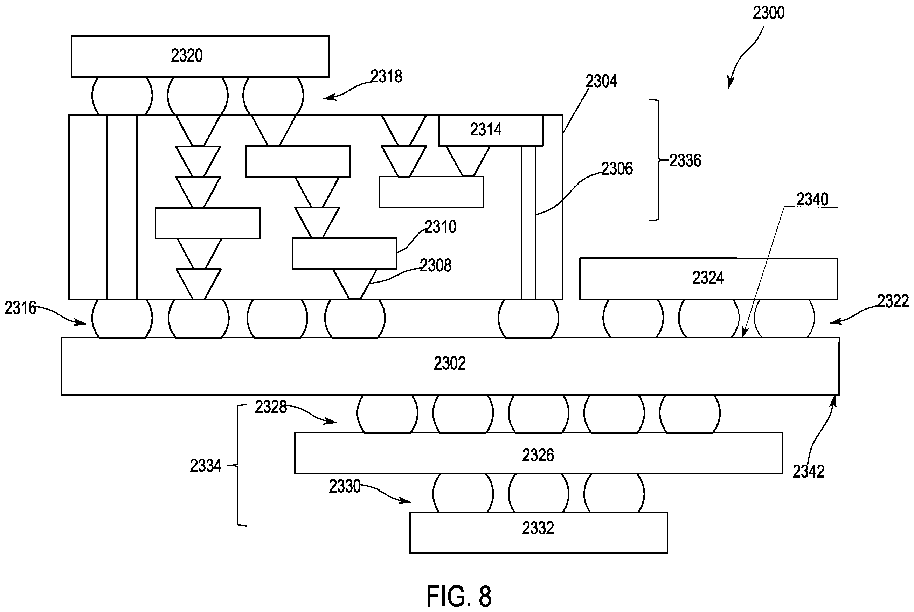

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (*e.g.*, for a ball grid array (BGA) arrangement), but any suitable second-level interconnects 2270 may be used (*e.g*., pins in a pin grid array arrangement or lands in a land grid array arrangement). Second-level interconnects 2270 may be used to couple IC package 2200 to another component, such as a circuit board (*e.g*., a motherboard), an interposer, or another IC package, as known in the art and as discussed below with reference to FIG. 8.

In various embodiments, any of dies 2256 may be microelectronic assembly 100 as described herein. In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (*e.g*., silicon-based dies), one or more of dies 2256 may be memory dies (*e.g*., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 8 is a cross-sectional side view of an IC device assembly 2300 that may include components having one or more microelectronic assembly 100 in accordance with any of the embodiments disclosed herein. At least some of the components described in FIG. 8 may be substantially similar to the components described in the preceding figures, for example, FIG. 1. IC device assembly 2300 includes a number of components disposed over a circuit board 2302 (which may be, *e.g.,* a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; *e.g*., any of the IC packages discussed below with reference to IC device assembly 2300 may take the form of any of the embodiments of IC package 2200 discussed above with reference to FIG. 7.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, *e.g.,* as described above with reference to FIG. 5. In some embodiments, IC package 2320 may include at least one microelectronic assembly 100 as described herein. Microelectronic assembly 100 is not specifically shown in the figure in order to not clutter the drawing.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 9 is a block diagram of an example computing device 2400 that may include one or more components having one or more IC packages in accordance with any of the embodiments disclosed herein. For example, any suitable ones of the components of computing device 2400 may include a microelectronic assembly (e.g., 100) in accordance with any of the embodiments disclosed herein. In another example, any one or more of the components of computing device 2400 may include any embodiments of IC package 2200 (e.g., as shown in FIG. 7). In yet another example, any one or more of the components of computing device 2400 may include an IC device assembly 2300 (e.g., as shown in FIG. 8).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (*e.g.*, connectors and supporting circuitry) to which audio input device 2418 or audio output device 2408 may be coupled.

Computing device 2400 may include a processing device 2402 (*e.g.*, one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (*e.g*., dynamic random access memory (DRAM)), nonvolatile memory (*e.g.*, read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (*e.g.*, one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (*e.g*., IEEE 802.16-2005 Amendment), LTE project along with any amendments, updates, and/or revisions (*e.g*., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (*e.g*., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (*e.g*., batteries or capacitors) and/or circuitry for coupling components of computing device 2400 to an energy source separate from computing device 2400 *(e.g.,* AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (*e.g*., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

### Select Examples

Example 1 provides a semiconductor die, comprising: a first bond-pad on a first surface to couple to a package substrate; a second bond-pad on a second surface, the second surface being opposite to the first surface; a hole through the semiconductor die; a conductive pillar within the hole separated from sidewalls of the hole by an air gap, the conductive pillar coupled to the first bond-pad and the second bond-pad; and pathways conductively coupling at least two integrated circuit (IC) dies proximate to the second surface.

Example 2 provides the semiconductor die of example 1, in which the first bond-pad and the second bond-pad are wider than the hole.

Example 3 provides the semiconductor die of any one of examples 1-2, in which the first bond-pad is directly coupled to an interconnect of one of the IC dies.

Example 4 provides the semiconductor die of example 3, in which the interconnect comprises solder.

Example 5 provides the semiconductor die of any one of examples 1-4, in which the second bond-pad is directly coupled to an interconnect of the package substrate.

Example 6 provides the semiconductor die of example 5, in which the interconnect comprises solder.

Example 7 provides the semiconductor die of any one of examples 1-6, in which the semiconductor die is within a cavity in the package substrate.

Example 8 provides the semiconductor die of any one of examples 1-7, in which the conductive pillar has a first width proximate to the first bond-pad and a second width proximate to the second bond-pad, and the first width is larger than the second width.

Example 9 provides the semiconductor die of any one of examples 1-8, in which the conductive pillar is in a first portion of the semiconductor die, the pathways are in a second portion of the semiconductor die, and the first portion and the second portion are mutually exclusive.

Example 10 provides the semiconductor die of example 9, in which the first portion is proximate to a periphery of the semiconductor die, and the second portion is proximate to a center of the semiconductor die.

Example 11 provides the semiconductor die of any one of examples 1-10, in which the semiconductor die is coupled to the IC dies by a first interconnect and a second interconnect, the first interconnect is physically coupled to the conductive pillar, and the second interconnect is physically coupled to the pathways.

Example 12 provides the semiconductor die of example 11, in which the first interconnect is larger than the second interconnect.

Example 13 provides the semiconductor die of any one of examples 1-12, in which the pathways comprise conductive traces and conductive vias in interlayer dielectric (ILD) material.

Example 14 provides the semiconductor die of example 13, in which the conductive pillar is wider than any one of the conductive vias.

Example 15 provides the semiconductor die of any one of examples 13-14, in which the ILD material comprises a compound of silicon and oxygen.

Example 16 provides the semiconductor die of any one of examples 1-15, in which the semiconductor die is less than 50 micrometers in thickness between the first surface and the second surface.

Example 17 provides the semiconductor die of any one of examples 1-16, in which the semiconductor die does not contain any active semiconductor element.

Example 18 provides the semiconductor die of any one of examples 1-17, in which the conductive pillar has an average width of less than 10 microns.

Example 19 provides the semiconductor die of any one of examples 1-18, in which a portion of the semiconductor die comprises bulk silicon.

Example 20 provides the semiconductor die of any one of examples 1-19, in which the conductive pillar comprises copper.

Example 21 provides an integrated circuit (IC) package, comprising: a package substrate having a surface with a blind cavity extending partially through the package substrate from the surface; a plurality of IC dies attached to the surface of the package substrate; and a bridge die in the blind cavity attached to the plurality of IC dies, the bridge die comprising: conductive pathways conductively coupling at least a pair of IC dies in the plurality if IC dies, through-silicon vias (TSVs) extending through a thickness of the bridge die, and an air gap around at least one TSV.

Example 22 provides the IC package of example 21, in which the at least one TSV is tapered toward the surface.

Example 23 provides the IC package of example 21, in which the at least one TSV is tapered away from the surface.

Example 24 provides the IC package of example 21, in which the air gap is broader proximate to the surface than distant from the surface.

Example 25 provides the IC package of example 21, in which the TSV is in a hole, the hole has substantially parallel sidewalls perpendicular to the surface, and the air gap is between the TSV and the sidewalls.

Example 26 provides the IC package of any one of examples 21-25, in which the plurality of IC dies is directly coupled to the bridge die by at least first interconnects and second interconnects, and the first interconnects are larger than the second interconnects.

Example 27 provides the IC package of example 26, in which the plurality of IC dies is directly coupled to the package substrate by third interconnects, and the third interconnects are larger than the second interconnects.

Example 28 provides the IC package of example 27, in which the third interconnects are similar in size to the first interconnects.

Example 29 provides the IC package of example 26, in which the bridge die is directly coupled to the package substrate by third interconnects, and the third interconnects are similar in size to the first interconnects.

Example 30 provides the IC package of example 29, in which the TSVs are directly coupled to the first interconnects and the third interconnects.

Example 31 provides a package substrate, comprising: buildup layers; a cavity in the buildup layers; and a semiconductor die in the cavity, the semiconductor die comprising: a plurality of conductive vias proximate to a periphery of the semiconductor die, in which each conductive via extends through a thickness of the semiconductor die, and an air gap surrounds each conductive via.

Example 32 provides the package substrate of example 31, in which each air gap is capped by a bond-pad on either end of the air gap, and the corresponding conductive via within the air gap is directly coupled to the bond-pads on either end of the air gap.

Example 33 provides the package substrate of example 32, in which the bond-pads are wider than the air gap.

Example 34 provides the package substrate of any one of examples 31-33, in which the semiconductor die comprises a substrate including silicon; layers of metallization including conductive traces; interlayer dielectric (ILD) material between the layers and in the layers between the conductive traces; and conductive vias through the ILD material, and the air gap around each conductive via extends through the substrate and the ILD material.

Example 35 provides the package substrate of any one of examples 31-34, in which the semiconductor die is coupled to interconnects at a bottom of the cavity, and each interconnect is directly coupled to one of the conductive vias.

Example 36 provides a method, comprising: providing a wafer of semiconductor material having a first surface and an opposing second surface; forming through-holes in the wafer, each through-hole extending through a thickness of the wafer between the first surface and the second surface; adding conductive material in the through-holes such that a gap exists laterally between sidewalls of each through-hole and the conductive material; and forming bond-pads on the first surface and the second surface, at least a subset of the bond-pads covering each through-hole on the first surface and the second surface such that the conductive material in each through-hole is directly coupled to bond-pads on the first surface and the second surface.

Example 37 provides the method of example 36, further comprising: planarizing the first surface and the second surface before forming the bond-pads.

Example 38 provides the method of any one of examples 36-37, in which the bond-pads on the first surface are formed before forming the bond-pads on the second surface.

Example 39 provides the method of any one of examples 36-38, in which the through-holes are formed by reactive ion etching.

Example 40 provides the method of any one of examples 36-39, in which the conductive material is added in the through-holes by electron beam physical vapor deposition at pressures below 1 microbar.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

## Claims

1. A semiconductor die, comprising:
a first bond-pad on a first surface to couple to a package substrate;
a second bond-pad on a second surface, the second surface being opposite to the first surface;
a hole through the semiconductor die;
a conductive pillar within the hole separated from sidewalls of the hole by an air gap, the conductive pillar coupled to the first bond-pad and the second bond-pad; and
pathways conductively coupling at least two integrated circuit (IC) dies proximate to the second surface.

2. The semiconductor die of claim 1, wherein the first bond-pad and the second bond-pad are wider than the hole.

3. The semiconductor die of claim 1 or 2, wherein the first bond-pad is directly coupled to an interconnect of one of the IC dies.

4. The semiconductor die of any one of claims 1-3, wherein the second bond-pad is directly coupled to an interconnect of the package substrate.

5. The semiconductor die of any one of claims 1-4, wherein:
the conductive pillar has a first width proximate to the first bond-pad and a second width proximate to the second bond-pad, and
the first width is larger than the second width.

6. The semiconductor die of any one of claims 1-4, wherein:
the conductive pillar is in a first portion of the semiconductor die,
the pathways are in a second portion of the semiconductor die, and
the first portion and the second portion are mutually exclusive.

7. The semiconductor die of claim 6, wherein:
the first portion is proximate to a periphery of the semiconductor die, and
the second portion is proximate to a center of the semiconductor die.

8. An integrated circuit (IC) package, comprising:
a package substrate having a surface with a blind cavity extending partially through the package substrate from the surface;
a plurality of IC dies attached to the surface of the package substrate; and
a bridge die in the blind cavity attached to the plurality of IC dies, the bridge die comprising:
conductive pathways conductively coupling at least a pair of IC dies in the plurality if IC dies;
through-silicon vias (TSVs) extending through a thickness of the bridge die; and
an air gap around at least one TSV.

9. The IC package of claim 8, wherein:
the TSV is in a hole,
the hole has substantially parallel sidewalls perpendicular to the surface, and
the air gap is between the TSV and the sidewalls.

10. The IC package of claim 8 or 9, wherein:
the plurality of IC dies is directly coupled to the bridge die by at least first interconnects and second interconnects, and
the first interconnects are larger than the second interconnects.

11. The IC package of claim 10, wherein the second interconnects are similar in size to the first interconnects.

12. A package substrate, comprising:
buildup layers;
a cavity in the buildup layers; and
a semiconductor die in the cavity, the semiconductor die comprising a plurality of conductive vias proximate to a periphery of the semiconductor die, wherein:
each conductive via extends through a thickness of the semiconductor die, and
an air gap surrounds each conductive via.

13. The package substrate of claim 12, wherein:
each air gap is capped by a bond-pad on either end of the air gap, and
the corresponding conductive via within the air gap is directly coupled to the bond-pads on either end of the air gap.

14. The package substrate of claim 13, wherein the bond-pads are wider than the air gap.

15. The package substrate of any one of claims 12-14, wherein:
the semiconductor die is coupled to interconnects at a bottom of the cavity, and
each interconnect is directly coupled to one of the conductive vias.
